# EUROPEAN PATENT APPLICATION

(11) **EP 1 376 476 A1**
(43) Date of publication of application: **02.01.2004**
(21) Application number: 02013531.5
(22) Date of filing: 18.06.2002
(51) Int. Cl.: G06T 17/40

(54) **Problem solving by a CAD program**

(71) Applicant: Autodesk, Inc., San Rafael, California 94903 (US)
(72) Inventor: Meisenecker, Robert, D-80337 München (DE)
(74) Representative: Dendorfer, Claus, Dr.

(57) **Abstract**

In a method for solving problems that are related to geometrical properties of objects processed by a CAD program, a possible problem related to a geometrical property of at least one object is identified, and an indicator symbol is displayed in a drawing window of the CAD program. The indicator symbol is shown in graphical association with at least one entity processed by the CAD program, the entity being related to the identified possible problem. A user action related to the indicator symbol is received, and problem solving assistance is provided to the user in response to the user action. A computer program product and an apparatus comprise corresponding features. The invention provides a way for solving problems related to geometrical properties of objects processed by a CAD program that minimizes workflow disruption even in cases where the problem cannot be solved in an entirely automatic way.

## Description

The invention concerns the field of computer aided design (CAD) software and in particular the field of solving problems that are related to geometrical properties of objects processed by a CAD program. Such problems may, for example, be caused by invalid or undesired geometrical properties of one object or by invalid or undesired geometrical constellations of two or more objects processed by the CAD program.

The use of computer aided design techniques has become common practice in many fields like, for example, engineering or architecture. Available computer aided design programs range from relatively simple drawing tools to sophisticated systems that cover the whole range of product or architectural design and possibly further aspects like, for example, manufacturing or construction. The term "computer aided design (CAD) program" used herein should therefore be understood in its broadest meaning as any computer program that contains a drawing and/or design component and possibly further components. A widely used CAD program is the AutoCAD® program manufactured by Autodesk, Inc., San Rafael, California. Several further application-specific CAD products are available like, for example, the Autodesk® Architectural Desktop™ program for architectural design.

In the course of using a CAD program, an invalid constellation of geometrical primitives processed by the CAD program may arise. Such an invalid constellation may, for example, prevent successful execution of a complex automatic function of the CAD program or of a complex macro. It may also be the result of an automatic function or of a manual user action. One known possibility of handling this situation is that operations which lead to the invalid geometrical property or in which the invalid geometrical property is noticed are completely aborted. In this case, an operation initiated by the user will not be carried out. It is also known to carry out the operation while ignoring the error or the wrong result. The user may be informed about the problem by drawing an error symbol or opening an error dialog box. In any case, the result of the operation will not be the result intended by the user, and the problem will not be solved. The error symbol or the error dialog box usually are very general and therefore do not help the user in resolving the error situation.

One reason for this prior art approach is that there is often no unique and clear solution to the problem without obtaining user assistance. Since operations on geometrical primitives are often time-critical operations like moving, rotating or stretching, user feedback when carrying out the operation would entail prompting the user during the real-time operation. This is undesirable since it would disrupt the workflow. This kind of situation, where a problem cannot be solved without user interaction, and user interaction cannot be requested since the request would disrupt the workflow, occurs quite frequently in the field of CAD programs.

An object of the present invention is therefore to provide a way for solving problems related to geometrical properties of objects processed by a CAD program that minimizes workflow disruption even in cases where the problem cannot be solved in an entirely automatic way.

The invention comprises a method having the features of claim 1, a computer program product having the features of claims 9 and an apparatus having the features of claim 10. The dependent claims define preferred embodiments of the invention. The order of the steps recited in the claims should not be construed as a limitation of the scope of the present invention. The invention comprises all embodiments in which the recited method steps are performed in a different order or in a parallel or interleaved (quasi-parallel) fashion.

The invention is based on the idea to display an appropriate indicator symbol (which may be a "problem resolution symbol" in some embodiments) when a possible problem related to a geometrical property of at least one object processed by the CAD program is detected. The indicator symbol is shown in graphical association with at least one entity that is related to the possible problem (e.g., an entity that may be the cause of the problem or that may be affected by the problem). After receiving a user action related to the indicator symbol (e.g., a mouse click onto the symbol or a command identifying the symbol - such an identifying relation may also be implicit if only one indicator symbol is shown at the present time), appropriate problem solving assistance is provided to the user.

The problem resolution process of the present invention is user-assisted. This entails the advantage that many problem situations can be handled by the method of the present invention which would not be resolvable without the user's help. Furthermore, displaying indicator symbols does not interrupt the user's workflow. The user may decide whether and when to deal with the indicated geometric problems. This is in contrast to prior art methods in which modal error dialog boxes are used.

It is preferred that the user will be provided with one or more commands that serve to solve the problem. Preferably only problem resolution commands are shown which are applicable in the current context. In preferred embodiments a further user action or confirmation is required before any command suggested by the system is executed.

In preferred embodiments, problem resolution can be requested by the user. This increases the possibilities for the user to provide information to the system, thus making it possible to address more problems than in the prior art. In some embodiments the user may be prompted to indicate a graphical entity associated with the possible problem when he or she requests problem resolution. The user may also request in some embodiments that the whole drawing or the whole model is scanned for invalid geometry. Preferably an appropriate indicator symbol is generated for each detected possible problem.

The problem solving assistance provided to the user may comprise a description of the problem (e.g., a detailed textual diagnosis) and/or of possible ways to solve the problem automatically or by hand. The indicator symbol is preferably removed from the drawing window after the problem has been solved. In preferred embodiments, the indicator symbol may represent knowledge about what went wrong, and how to resolve the invalid geometrical constellation. Additionally, the indicator symbol may be decorated by a connection line to another graphical object involved in the problem.

Preferred embodiments of the computer program product and the apparatus of the present invention also comprise features corresponding to the features described above and/or to the features defined in the dependent method claims.

Further features, objects and advantages of the invention will be apparent from the following detailed description of several sample embodiments thereof. Reference is made to the schematic drawings, in which:
Fig. 1 shows a drawing window and two objects controlled by a prior art CAD program,
Fig. 2 - Fig. 5 show a drawing window and two objects controlled by a CAD program during a problem solving process in a first sample embodiment of the present invention, and
Fig. 6 - Fig. 10 show a drawing window and two objects controlled by a CAD program during a problem solving process in a second sample embodiment of the present invention.

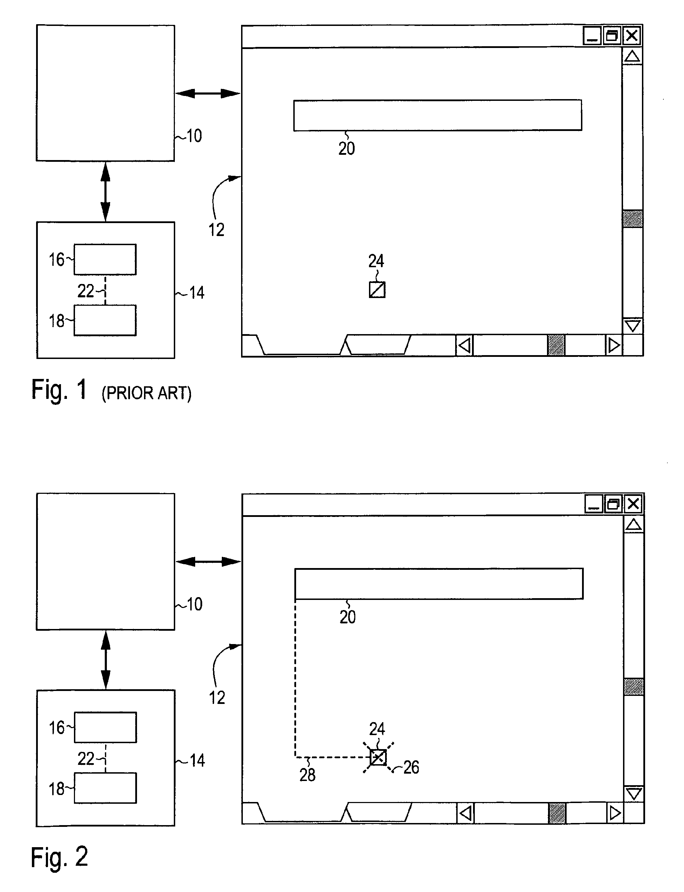

The schematic representation of Fig. 1 - Fig. 10 depicts a CAD program 10. The CAD program 10 shown in Fig. 1 is the presently available Autodesk® Architectural Desktop™ product, whereas the CAD program 10 of Fig. 2 - Fig. 10 is a variant of this product which has been enhanced to incorporate the teachings of the present invention. The CAD program 10 is executed by a common personal computer or a workstation. A user enters commands for the CAD program 10 in a well-known way, e.g., via a keyboard or a mouse or a drawing tablet. Output means like, e.g., a CRT screen are provided for showing user interface elements. The user interface elements comprise a drawing window 12 and other elements like, e.g., command menus or command prompts or dialog boxes.

The CAD program 10 controls the drawing window 12 and accesses an object memory 14. While some of the objects stored in the object memory 14 serve for internal administrative purposes only, other objects are represented by corresponding drawing elements in the drawing window 14. In the example of Fig. 1 - Fig. 5, the object memory 14 contains, among other objects, a wall object 16 and a dimension object 18. The wall object 16 models a wall of a building that is to be designed, and the dimension object 18 contains dimensioning data related to this wall. The wall object 16 is represented in the drawing window 14 by a rectangle 20, which is the proper drawing representation of a top view of the wall.

In the present example, the wall (rectangle 20) is to be dimensioned using the AEC functionality of the CAD program 10. This functionality provides a variety of objects and commands specifically tailored to the fields of architecture, engineering and construction. The user initiates the automatic dimensioning process by creating the dimension object 18 and attaching it to the wall object 16. The newly created dimension object 18 and a reference 22 between the dimension object 18 and the wall object 16 are stored in the object memory 14. The AEC functionality built into the CAD program 10 is such that the dimension object 18 retrieves its dimension points at a certain section height of the object that is to be dimensioned, namely the wall object 16 in the present example. This height - the so-called cutplane height - is defined by display properties of the wall object 16, which may be set by the user.

It is now assumed that the user has set the cutplane height of the wall object 16 to a value which is larger than the height of the wall. This represents an invalid geometrical property of the wall object 16 since the cutplane defined by the cutplane height does not intersect the wall. The consequence of this problem is that retrieving dimension points at the given cutplane height is impossible. The CAD program 10 is thus not able to create a proper dimensioning symbol to be shown in the drawing window 12. A dimension error symbol 24, namely a small square with a diagonal line, is shown instead. In the prior art system of Fig. 1 there is no further information for the user indicating what exactly went wrong.

Fig. 2 shows the same situation as that of Fig. 1 for a CAD program 10 according to the present invention. Again, the dimension error symbol 24 is displayed since no proper dimensioning is possible. However, the CAD program 10 identifies the problem related to the invalid cutplane setting in the wall object 16. An indicator symbol 26 (e.g., a bold dotted cross in Fig. 2 or a red cross on a color display) is shown on top of the dimension error symbol. The indicator symbol 26 signifies that the CAD program 10 is able to provide problem resolution assistance with respect to the present problem. Furthermore, a reference line 28 is shown, which provides a clear graphical association between the dimensioning (represented by the dimension error symbol 24), which is affected by the problem, and the wall (represented by the rectangle 20), which is the cause of the problem.

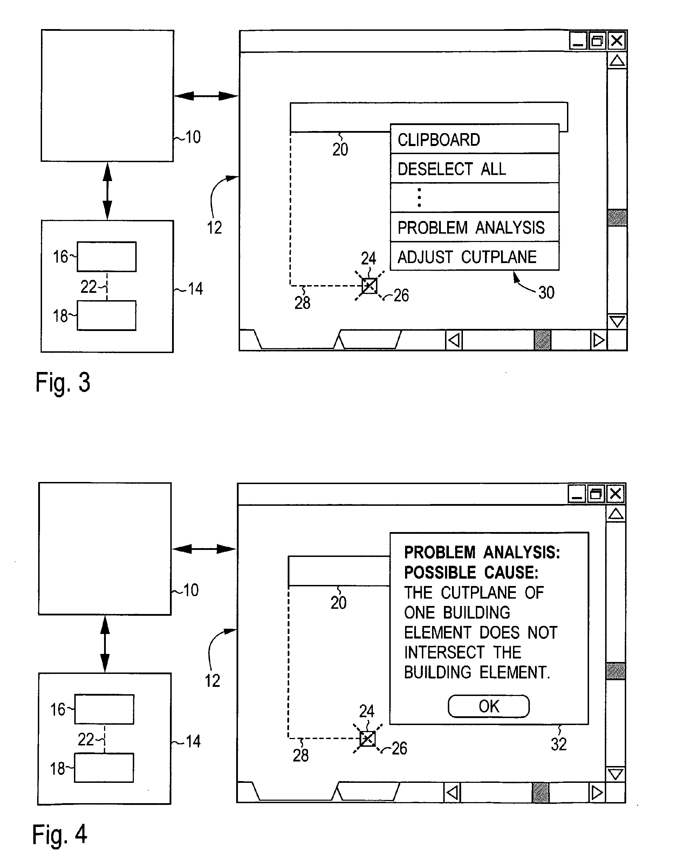

The user now performs a predefined user action to access the problem solving functions of the CAD program 10. In the present example a right-button mouse click onto the indicator symbol 26 ("problem resolution symbol") is used, but the user action may also comprise typing a command or pressing a special key or selecting an active display region. In response to the user action, a context menu 30 - shown in Fig. 3 - appears. The context menu 30 offers a plurality of well known entries and the additional choices "Problem Analysis" and "Adjust Cutplane". These two entries are used for resolving the invalid geometrical constellation.

If the user selects the item "Problem Analysis" of the context menu 30, a dialog box 32 - shown in Fig. 4 - with a detailed description of the problem and possibly with hints for its (manual or automatic) solution will be presented. For example, the hint in the present case may read: "The problem might be resolved by setting the cutplane height to 0.0".

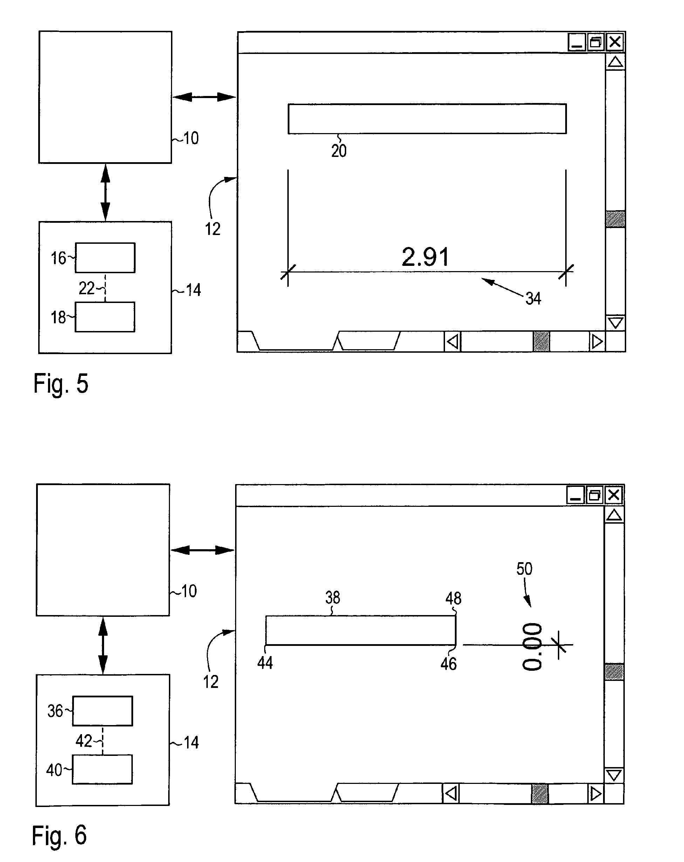

If the user selects the problem solving command "Adjust Cutplane" from the context menu 30, the problem will be resolved automatically. The CAD program 10 then adjusts the cutplane height such that the wall is intersected by the adjusted cutplane. The correct dimensioning points are then determined, and the standard-conforming dimensioning 34 - shown in Fig. 5 - is generated and depicted in the drawing window 12. The indicator symbol 26 is removed since the problem has been resolved.

It should be noted that the problem solving command "Adjust Cutplane" has been automatically determined by the CAD program 10 as a command that would be suitable for resolving the present problem. In other situations two or more possible commands might be applicable. All of these commands will then be shown in the context menu 30, and the appropriate one can be selected by the user. No problem resolution steps will be taken automatically. In other words, any action of the system requires at least one step of user interaction. Thus the user can be kept informed and undesired effects of the problem solving steps are avoided.

In the above example the CAD program 10 has been able to spot the geometrical problem when carrying out the requested dimensioning operation, such that it was possible to create the indicator symbol 26 automatically. This is not the case in the following example, which is illustrated in Fig. 6 - Fig. 10. The example again concerns a wall object 36 (represented by a rectangle 38 in the drawing window 12) that is to be dimensioned using the AEC dimensions function. It is assumed that the wall (rectangle 38) is not exactly aligned horizontally, i.e., at 0.0 degrees. This might be because the user drew the wall without the orthogonal drawing mode offered by the CAD program 10. This very likely leads to a wall which is slightly misaligned, e.g., has an angle of 0.005 degrees with respect to the true horizontal.

In order to dimension the wall, the CAD program 10 creates an appropriate dimension object 40 and a reference 42 to the wall object 36 in the object memory 14. The predefined mode of operation of the AEC dimensions function is that the dimension object 40 retrieves its dimension points from that side of the building element to be dimensioned which faces a point indicated by the user when giving the dimensioning command. The angle of the building element to be dimensioned is taken into consideration for determining which side of the building element is the facing side.

In the example of Fig. 6, the system incorrectly dimensioned the bottom side of the rectangle 38 (side between corners 44 and 46) instead of the right hand side (side between corners 46 and 48). This problem is due to an incorrect determination of the "facing side" because of the slight rotation of the wall. A dimensioning 50 with the distance indication "0.00" is created since the dimensioning shows the vertical distance between the corners 44 and 46, which is very close to zero. In the present sample embodiment the system does not determine automatically that a problem exists since it was possible to create a proper dimensioning 50 (albeit not the one intended by the user). No indicator symbol indicating a possible problem will therefore be shown. Alternative embodiments may be more liberal in drawing the attention of the user to possible problems. For example, a dimensioning value of "0.00" may already be regarded as a warning sign that justifies displaying of a corresponding problem indicator symbol.

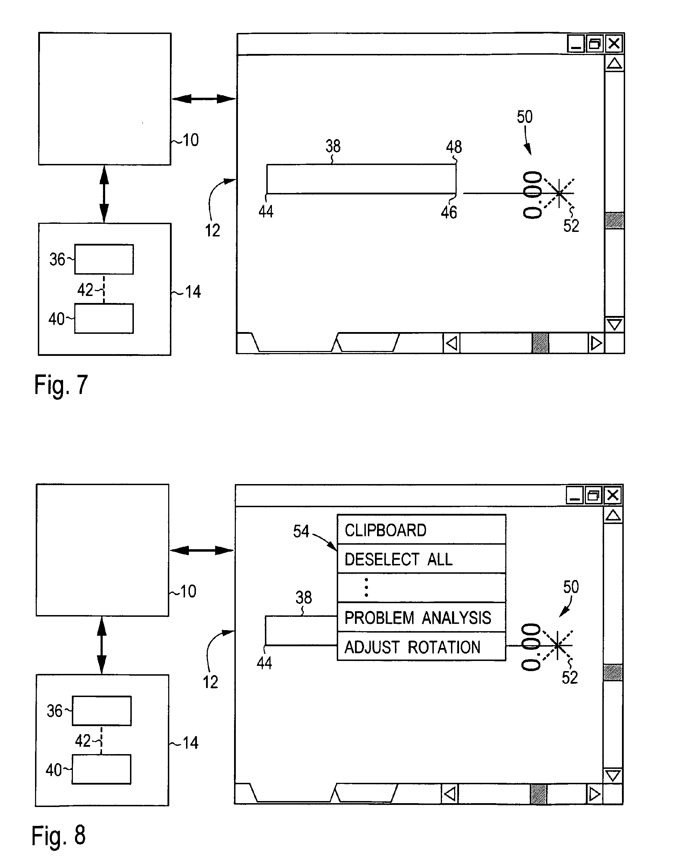

The user, seeing the representation in the drawing window 12 of Fig. 6, notices that "something is wrong". He or she issues an appropriate command (named, e.g., "ResolveGeometricProblem"), indicating that an invalid geometrical constellation exists and is to be resolved. The "ResolveGeometricProblem" command prompts the user to indicate an entity shown in the drawing window 12 which is related to the problem. In the present example, the user picks the invalid dimensioning 50. The system is then able to tentatively detect the problem and creates an indicator symbol 52 next to the dimensioning 50. This is shown in Fig. 7. In cases where more than one possible problem are identified, a corresponding number of indicator symbols will be shown, each one at a position which gives the user some information about the corresponding problem.

When the user right-clicks onto the indicator symbol 52, a context menu 54 - shown in Fig. 8 - appears. The context menu 54 contains, besides the usual entries, two additional items "Problem Analysis" and "Adjust Rotation". These additional entries have been created by the system for assisting the user in the resolution of the invalid geometrical constellation.

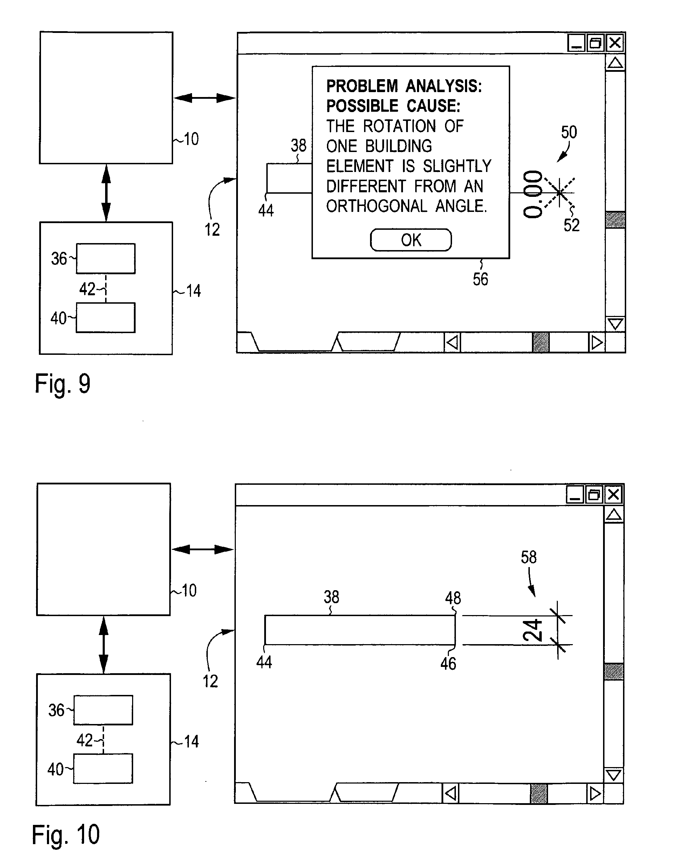

If the user selects the "Problem Analysis" item of the context menu 54, a dialog box 56 with a detailed problem description - shown in Fig. 9 - is presented. The dialog box 56 may also contain one or more hints for solving the problem like, e.g.: "The problem may be resolved by adjusting the rotation of the building element."

If the user selects the "Adjust Rotation" entry in the context menu 54, the problem will be resolved automatically. The CAD program 10 changes the wall rotation to exactly 0.0 degrees. This in turn causes the AEC dimensions function to change the side of the rectangle 38 to be dimensioned; the new side will be the right hand side delimited by corners 46 and 48. A new dimensioning 58 is then created and shown in the drawing window 12 - see Fig. 10. The indicator symbol 52 is removed since the invalid geometric constellation (i.e., a dimensioned wall which has a slightly "wrong" rotation) has been successfully detected and resolved with the help of the user.

It is to be understood that the application possibilities and embodiments described above represent just some examples, and that a wide range of further applications of the teachings of the present invention exist and are readily apparent to the expert.

## Claims

1. A method for solving problems that are related to geometrical properties of objects (36, 40) processed by a CAD program (10), said method comprising the following steps performed by a computer:
- identifying a possible problem related to a geometrical property of at least one object (36, 40) processed by said CAD program (10),
- displaying an indicator symbol (26, 52) in a drawing window (12) of said CAD program (10), said indicator symbol (26, 52) being shown in graphical association with at least one entity (20, 24, 38, 50) processed by said CAD program (10), said entity (20, 24, 38, 50) being related to said identified possible problem,
- receiving a user action related to the indicator symbol (26, 52),
- providing problem solving assistance to the user in response to said user action.

2. The method of claim 1, wherein said problem solving assistance provided to said user comprises presenting said user with at least one problem solving command.

3. The method of claim 2, wherein said problem solving command is only executed in response to a further user action.

4. The method of one of claims 1 to 3, wherein said problem solving assistance provided to said user comprises presenting said user with a description of said possible problem.

5. The method of one of claims 1 to 4, wherein said possible problem is identified by the computer during execution of an operation of said CAD program (10).

6. The method of claim 5, wherein said operation of said CAD program (10) is a dimensioning operation.

7. The method of one of claims 1 to 4, wherein said possible problem is identified in response to an initial user action indicating at least one problem-related entity (50) processed by said CAD program.

8. The method of one of claims 1 to 7, comprising the further steps of:
- determining whether or not the problem has been solved, and
- removing the indicator symbol (26, 52) if the problem has been solved.

9. A computer program product for execution by at least one computer, said computer program product comprising instructions for causing said at least one computer to perform the steps of the method of one of claims 1 to 8.

10. An apparatus comprising at least one computer, said at least one computer being programmed for performing the steps of the method of one of claims 1 to 8.
